Europäisches Patentamt

European Patent Office

Office européen des brevets

(11) Veröffentlichungsnummer: **0 292 015**
**A1**

## (12) EUROPÄISCHE PATENTANMELDUNG

(21) Anmeldenummer: **88108162.4**

(22) Anmeldetag: **20.05.88**

(51) Int. Cl.⁴: **H01L 23/48 , H01L 23/04**

(30) Priorität: **21.05.87 DE 3717161**

(43) Veröffentlichungstag der Anmeldung:
**23.11.88 Patentblatt 88/47**

(84) Benannte Vertragsstaaten:
**CH DE FR GB IT LI SE**

(71) Anmelder: **Siemens Aktiengesellschaft Berlin und München**
**Wittelsbacherplatz 2**
**D-8000 München 2(DE)**

(72) Erfinder: **Johansen, Jon-Willy**
**Ludwig Ganghoferstrasse 25**
**D-8011 Kirchheim(DE)**

(54) **Leistungshalbleiterbauelement.**

(57) Werden druckkontaktierte Leistungshalbleiterbauelemente starken Lastwechseln unterzogen, so kann dies zum Verschweißen von Elektrode und Kontaktelektrode führen und damit zum Ausfall bzw. Zerstören des Leistungshalbleiterbauelementes führen. Es wird eine Metallisierungsschichtfolge für eine zu druckkontaktierende Elektrode vorgeschlagen, die aus einer auf dem Halbleiterkörper aufliegenden Titan-Schicht (8) und darüberliegender Kupfer-Schicht (9) besteht. Zur Vermeidung von Oxidation der Oberfläche der Kupfer-Schicht (9) wird auf der Kupfer-Schicht (9) noch mindestens eine weitere Metallisierungsschicht angeordnet.

FIG 2

EP 0 292 015 A1

# Leistungshalbleiterbauelement

Die Erfindung betrifft ein Leistungshalbleiterbauelement mit einem mit Elektroden versehenen Halbleiterkörper, dessen Elektroden mit Elektrodenanschlüssen versehen sind, und bei dem mindestens eine der Elektroden aus mehreren übereinanderliegenden Metallisierungsschichten gebildet und zur Druckkontaktierung vorgesehen ist.

Ein solches Leistungshalbleiterbauelement ist z.B. in der DE-OS 21 22 487 beschrieben. Mindestens eine der Elektroden besteht aus einer Aluminiumschicht, die mit dem Halbleiterkörper in Kontakt steht. Diese Aluminiumschicht ist an ihrer Oberfläche mit einer Silberschicht versehen die unter Druck an einer Kontaktelektrode, die als Elektrodenanschluß wirkt, anliegt. Diese Silberschicht schützt die Aluminiumschicht vor Oxidation und bildet einen guten Kontakt zur Kontaktelektrode.

Werden solche Leistungshalbleiterbauelemente mit druckkontaktierten Elektrodenanschlüssen, die z.B. aus vernickelten Kupfer-Kontaktstücken bestehen können, versehen und starken Lastwechseln ausgesetzt, so führt dies oft zum Ausfall des Bauelementes. Das Ausfallbild stellt sich so dar: Das vernickelte Kupfer-Kontaktstück verschweißt an seinem Außenrand mit der Elektrode der Halbleitertablette, was bei weiteren Lastwechseln zu Rissen im Silicium und damit zum Verlust der Sperrfähigkeit und zum Durchbrennen der Bauelemente führt. Je höher die auftretenden Temperaturänderungen und je höher der Anpreßdruck ist, desto häufiger tritt dieser Ausfall auf.

Der vorliegenden Erfindung liegt die Aufgabe zugrunde, ein Leistungshalbleiterbauelement mit einer zur Druckkontaktierung vorgesehenen Elektrode zu versehen, die ein Zusammenschweißen von Elektrodenanschluß und Elektrode verhindert und zusätzlich eine gute laterale Leitfähigkeit aufweist.

Diese Aufgabe wird dadurch gelöst, daß eine Metallisierungsschicht eine Titan-Schicht ist, an derer dem Halbleiterkörper abgewandten Oberfläche eine Kupfer-Schicht angeordnet ist, und daß diese Kupfer-Schicht mindestens die Dicke der Titan-Schicht aufweist, und daß auf dieser Kupfer-Schicht mindestens eine weitere Metallisierungsschicht angeordnet ist.

Weiterbildungen der Erfindung sind der Gegenstand der Unteransprüche.

Durch die Verwendung von Kupfer, das auf der Mohsschen Härteskala etwa einen Härtegrad von 2,5 - 3 aufweist, als zweite Metallisierungsschicht wird im Gegensatz zur aus Aluminium gebildeten Elektrode eine geringere Materialwanderung bei Stromdurchgang (Elektromigration) erzielt. Außerdem weist Kupfer eine um ca. 1,6-fach höhere Leitfähigkeit als Aluminium auf.

Die zwischen Halbleiterkörper und Kupfer-Schicht angeordnete Titan-Schicht dient als Diffusionsbarriere zwischen Halbleiterkörper und Kupfer-Schicht und zugleich als Haftgrund. Titan hat zusätzlich den Vorteil, daß es nicht dotierend im Halbleiterkörper wirkt.

Eine Weiterbildung der Erfindung sieht vor, daß zwischen der Oberfläche des Halbleiterkörpers und der Titan-Schicht eine vorzugsweise bis zu 0,1 $\mu$m dünne Aluminium-Schicht angeordnet ist. Diese zusätzliche Aluminium-Schicht liefert einen guten ohmschen Kontakt zwischen Halbleiterkörper und der Elektrode. Ein unerwünschter Schottky-Kontakt wird somit vermieden. Um diesen Vorteil zu erreichen ist es auch möglich, an der Oberfläche des Halbleiterkörpers Aluminium einzudiffundieren oder einzulegieren.

In IBM Technical Disclosure, Bulletin, Vol. 29, NO 3, August 1986, Seite 1395 und 1396 ist zwar erwähnt, daß Kupfer als Metallisierungsschicht für Siliciumkörper verwendet werden kann. Als Diffusionsbarriere ist dort aber nur Tantal, Titan-Nitrid oder Siliciumnitrid erwähnt. Außerdem findet sich in dieser Druckschrift weder ein Hinweis darauf, daß ein Leistungshalbleiterbauelement zur Druckkontaktierung mit solchen Metallisierungsschichten versehen werden kann, noch darauf, wie dick die Kupferschicht sein soll.

Die Erfindung wird im folgenden anhand von Figuren näher erläutert. Es zeigen:

FIG 1 den Schnitt durch ein druckkontaktiertes Leistungshalbleiterbauelement,

FIG 2 Ausschnitt eines Leistungshalbleiterbauelementes mit erfindungsgemäßer Elektrode,

FIG 3a) Ausschnitt eines mit Aluminiumdiffusion versehenen Leistungshalbleiterbauelementes mit erfindungsgemäßer Elektrode,

FIG 3b) Ausschnitt durch ein druckkontaktiertes Leistungshalbleiterbauelement, bei dem zwischen Halbleiterkörper und Titan-Schicht eine Alumnium-Schicht angeordnet ist,

FIG 4 Ausschnitt eines Thyristors mit erfindungsgemäßer Elektrode, und

FIG 5 Ausschnitt eines weiteren Thyristors mit erfindungsgemäßer Elektrode.

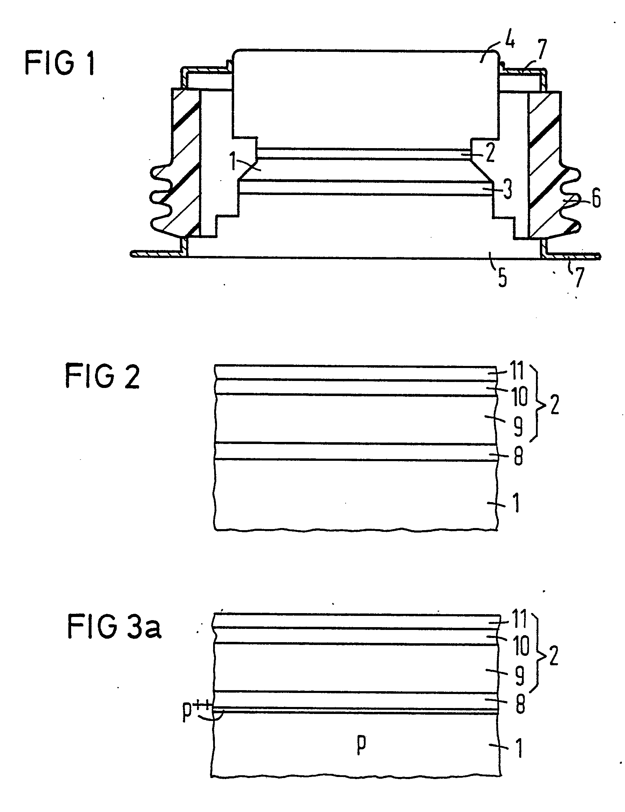

FIG 1 zeigt den Querschnitt eines gekapselten und druckkontaktierten Leistungshalbleiterbauelementes. Das Leistungshalbleiterbauelement weist einen Halbleiterkörper 1, z.B. eine aus Silicium oder Gallium-Arsenid bestehende Halbleiterscheibe, auf. Zur Druckkontaktierung weist der Halbleiterkörper 1 an seinen Hauptflächen angeordnete Elektroden 2, 3 auf. An diesen Elektroden 2, 3 liegt unter Druck jeweils eine Kontaktelektrode 4, 5 an. Diese Kontaktelektroden 4, 5 bilden Elektrodenanschlüs se für den Halbleiterkörper 1. Die beiden Kontaktelektroden 4, 5 und der dazwischen liegende Halbleiterkörper 1 mit seinen Elektroden 2, 3 sind mit einem zylinderförmigen Isolierstoffmantel 6 mit Ausgleichsflanschen 7 zu einem vorzugsweise gasdichten Gehäuse zusammengefügt. Die zur Kontaktbildung zwischen Kontaktelektrode 4 und Elektrode 2 bzw. Kontaktelektrode 5 und Elektrode 3 nötige Druckausübung wird z.B. dadurch erreicht, daß die Kontaktelektroden in das Gehäuse eingeschraubt werden, oder dadurch, daß spezielle Kühlkörper vorgesehen sind, in die das gesamte Leistungshalbleiterbauelement eingespannt wird und durch die Druck auf die Kontaktelektroden 4, 5 ausgeübt wird.

FIG 2 zeigt den Ausschnitt eines Leistungshalbleiterbauelementes, das mit einer Elektrode gemäß der Erfindung versehen ist. Dazu ist an den zur Kontaktierung vorgesehenen Bereich des Halbleiterkörpers 1 eine Elektrode 2 angeordnet. Diese Elektrode 2 besteht aus folgenden Metallisierungsschichten: Eine Titan-Schicht 8, die am zur Kontaktierung vorgesehenen Bereich des Halbleiterkörpers 1 anliegt, eine darüberliegende Kupfer-Schicht 9, eine auf der Kupfer-Schicht 9 aufliegende Titan-Schicht 10, und eine auf dieser Titan-Schicht 10 liegende Gold-Schicht 11.

Über die Dicke dieser Metallisierungsschichten sind folgende Bereiche gemäß der Erfindung einzuhalten:

| | |
|---|---|
| Titan-Schicht 8: | 0,05 $\mu$m bis 1 $\mu$m |
| Kupfer-Schicht 9: | 1 bis 10 $\mu$m |
| Titan-Schicht 10: | 0,05 bis 1$\mu$m |
| Gold-Schicht 11: | 0,1 bis 05 $\mu$m. |

Als günstig hat sich erwiesen, wenn die Titan-Schicht 8 0,3 $\mu$m, die Kupfer-Schicht 9 4 bis 5 $\mu$m, die Titan-Schicht 10 0,5 $\mu$m und die Gold-Schicht 11 0,1 $\mu$m dick ist.

Dadurch, daß die Kupfer-Schicht 10 1 - 200 mal dicker, vorzugsweise 10 - 20 mal dicker als die Titanschicht 8 und damit auch dicker als die übrigen Metallisierungsschichten gewählt ist, ergibt sich eine gute laterale Leitfähigkeit der Elektrode 2.

Die Titan-Schichten 8, 10 dienen als Diffusionsbarrieren für Kupfer gegen das Halbleiterkörpermaterial, z.B. Silicum, oder gegen die aufgebrachte Gold-Schicht 11. Die auf der Kupfer-Schicht 9 aufgebrachte Titan-Schicht 10 mit darüberliegender Gold-Schicht 11 vermeidet, daß die Kupferoberfläche der Kupfer-Schicht 9 oxidiert und so zur Kontaktverschlechterung beiträgt. Die Titan-Schicht 8 hat zusätzlich den Vorteil, daß sie als guter Haftgrund für die darüberliegende Kupfer-Schicht 9 dient.

Diese Metallisierungsschichten 8, 9, 10 und 11 werden z.B. durch Aufdampfen oder Sputtern auf den Halbleiterkörper aufgebracht. Die Silicidbildung Titan-Silicium wird bei etwa 400°C in Formier- oder Wasserstoffgas ausgeführt.

FIG 3a zeigt eine zur Druckkontaktierung geeignete Elektrode, die auf einem dafür vorgesehenen Bereich eines Leistungshalbleiterkörpers 1 aufgebracht ist. Dieser Bereich des Halbleiterkörpers 1 ist z.B. p-dotiert. Um eine noch stärkere p-Dotierung am Rand dieses Bereiches zu erlangen und damit einen guten ohm'schen Kontakt zwischen Halbleiterkörper 1 und Elektrode 2 zu gewährleisten, kann z.B. an der Oberfläche dieses Bereiches des Halbleiterkörpers 1 Aluminium eindiffundiert oder einlegiert werden. Durch diese z.B. 100 nm dünne aluminiumdotierte Zone wird eine noch stärkere p-Dotierung am Rand des Bereiches des Halbleiterkörpers erreicht. Damit wird ein unerwünschter Schottky-Kontakt vermieden. Damit bildet sich ein guter ohmscher Kontakt zwischen Halbleiterkörper 1 und Elektrode. Die Metallisierungsschichten 8, 9, 10, 11 entsprechen denen in FIG 2 genannten.

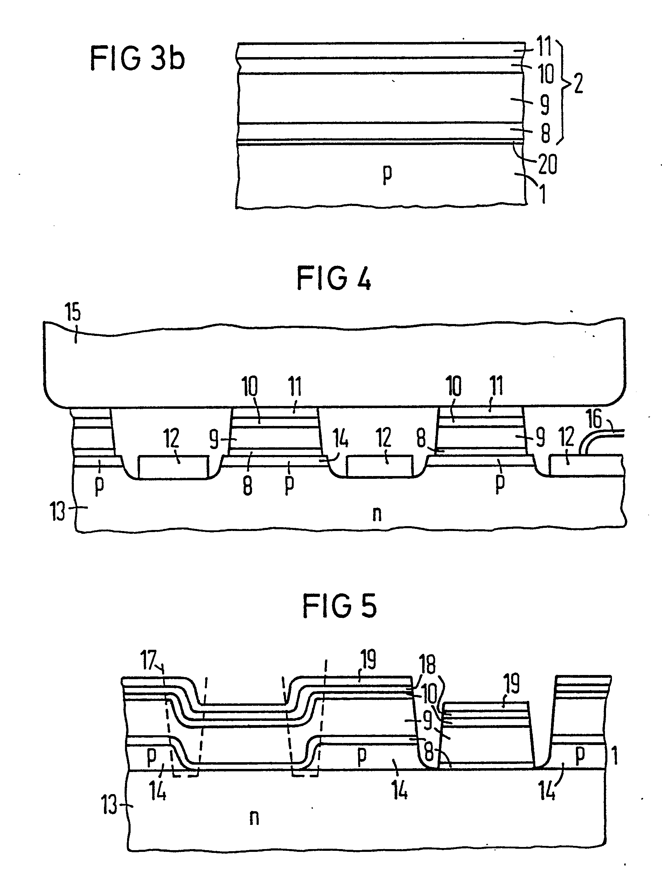

Es ist auch möglich, zwischen den Halbleiterkörper 1 und der Titanschicht 8 eine Aluminium-Schicht 20 anzuordnen, die vorzugsweise 0,1 $\mu$m dick ist (vgl. FIG 3b). Durch diese zusätzliche Aluminium-Schicht 20 wird ebenfalls ein guter ohmscher Kontakt zwischen Halbleiterkörper 1 und Elektrode 2 erreicht. Die be reits bekannten Bezugszeichen werden auch in FIG 3b) für die bereits bekannten Teile verwendet.

In FIG 4 ist z.B. ein Ausschnitt eines Thyristors dargestellt. Dieser Thyristor ist mit mindestens einer Elektrode zur Druckkontaktierung versehen. In FIG 4 ist die mit einer Gateelektrode 12 verbundene Basiszone mit 13 bezeichnet. Die an diese Basiszone 13 angrenzende Emitterzone 14 ist mit einer Elektrode gemäß der Erfindung und im Zusammenhang mit den FIG 2 und 3 erwähnten Metallisierungsschichten verbunden. Wie die Querschnittsdarstellung in FIG 4 zeigt, sind die Emitterzonen 14 des Halbleiterkörpers 1 inselförmig auf der Oberfläche des Halbleiterkörpers 1 verteilt. Diese Emitterzonen liegen im Vergleich zur kontaktierenden Fläche der Basiszonen höher. Ist die Elektrode 12 für die Basiszone 13 nicht dicker als die durch die Metallisierungsschichten 8, 9, 10, 11 gebildete Elektrode, so kann die Elektrode der Emitterzone 14 mit einer Kontaktelektrode druckkontaktiert werden. Diese Kontaktelektrode ist in FIG 4 mit 15 bezeichnet und liegt unter Druck auf den inselförmigen Emitterzonen auf. Die Elektrode 12 für die Basiszone 13 ist mit einem Gateanschluß 16 z.B. durch Löten oder Bonden verbunden.

In FIG 5 ist eine Weiterbildung der Erfindung anhand eines Ausschnitts eines Thyristors gezeigt. Dieser Ausschnitt des Thyristors entspricht dem Ausschnitt nach FIG 4. Im Gegensatz zur FIG 4 besteht jetzt die Elektrode der Basiszone 13 und die Elekroden der Emitterzonen 14 aus den gleichen Metallisierungsschichten. Dies hat den Vorteil, daß für die Herstellung der Elektrode für die Basiszone 13 und für die Elektroden der Emitterzonen 14 der gleiche Herstellungsprozeß angewandt werden kann. Nachdem die einzelnen Metallisierungsschichten auf den gesamten Halbleiterkörper 1 aufgebracht worden sind. werden die Metallisierungsschichten mit einer Ätzmaske entsprechend den strichlierten Linien 17 wieder entfernt, um so einen Kurzschluß zwischen Elektrode der Emitterzonen 14 und Elektrode der Basiszonen 13 zu vermeiden.

Die in FIG 5 dargestellt Elektrode unterscheidet sich von den bisher genannten erfindungsgemäßen Elektroden dadurch, daß auf der Titan-Schicht 10 eine Nickel-Schicht 18 und eine darüberliegende Gold-Schicht 19 angeordnet ist. Die Dicke der Nickel-Schicht 18 beträgt dabei 0,1 bis 1 μm, die Dicke der Gold-Schicht 19 0,1 bis 0,5 μm. Diese Elektrodenstruktur hat zusätzlich den Vorteil, daß sie neben den erfindungsgemäßen Eigenschaften auch noch gut bondbar und lötbar ist.

Im Gegensatz zu bisher bekannt gewordenen Elektrodenanordnungen hat die erfindungsgemäße Elektrodenstruktur eine geringere Dicke. Dies führt beim chemischen Ätzen zu einer geringeren Unterätzung. Damit läßt sich auch eine höhere Ätzrate beim Plasmaätzen erreichen, als dies bei bisher bekannten Elektroden der Fall ist.

Die Kontaktelektroden - also das Gegenstück zu den auf dem Halbleiterkörper angeordneten Elektroden - können aus versilbertem Kupfer oder vernickeltem Kupfer bestehen. Genausogut können auch versilberte Aluminiumkontaktelektroden verwendet werden oder vernickelte bzw. versilberte Molybdänkontaktelektroden.

**Ansprüche**

1. Leistungshalbleiterbauelement mit einem mit Elektroden versehenen Halbleiterkörper, dessen Elektroden mit Elektrodenanschlüssen versehen sind, und bei dem mindestens eine der Elektroden aus mehreren übereinanderliegenden Metallisierungsschichten gebildet und zur Druckkontaktierung vorgesehen ist,
**dadurch gekennzeichnet,**
daß eine Metallisierungsschicht eine Titan-Schicht (8) ist, an derer dem Halbleiterkörper (1) abgewandten Oberfläche eine Kupfer-Schicht (9) angeordnet ist, und daß diese Kupfer-Schicht (9) mindestens die Dicke der Titan-Schicht (8) aufweist, und daß auf dieser Kupfer-Schicht mindestens eine weitere Metallisierungsschicht (10, 11) angeordnet ist.

2. Leistungshalbleiterbauelement nach Anspruch 1,
**dadurch gekennzeichnet,**
daß auf der Kupfer-Schicht (9) eine Titan-Schicht (10) mit darüberliegender Gold-Schicht (11) angeordnet ist.

3. Leistungshalbleiterbauelement nach Anspruch 1,
**dadurch gekennzeichnet,**
daß auf der Kupfer-Schicht (9) eine Titan-Schicht (10) mit darüberliegender Nickel-Schicht (18) und darüberliegender Gold-Schicht (19) angeordnet ist.

4. Leistungshalbleiterbauelement nach einem der Ansprüche 1 bis 3,
**dadurch gekennzeichnet,**
daß die Kupfer-Schicht (9) 10 bis 20 mal dicker als die Titan-Schicht (8) ist.

5. Leistungshalbleiterbauelement nach einem der Ansprüche 1 bis 4,
**dadurch gekennzeichnet,**
daß ein mit der Elektrode in Kontakt stehender Bereich des Halbleiterkörpers (1) p-dotiert ist, daß zwischen der ersten Metallisierungsschicht (8) und dem Halbleiterkörper (1) in diesem Bereich Aluminium zur Erhöhung der Dotierstoffkonzentration eindiffundiert oder einlegiert ist.

6. Leistungshalbleiterbauelement nach einem der Ansprüche 1 bis 5,
**dadurch gekennzeichnet,**
daß zwischen der Oberfläche des Halbleiterkörpers (1) und der Titan-Schicht (8) eine Aluminium-Schicht (20) angeordnet ist.

FIG 1

FIG 2

FIG 3a

FIG 3b

FIG 4

FIG 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | DE-A-2 642 721 (BOSCH) <br> * Seite 8, Abschnitte 2,5,6; Anspruch 1 * <br> --- | 1-3 | H 01 L 23/48 <br> H 01 L 23/04 |
| A | DE-A-3 044 514 (HITACHI) <br> * Ansprüche 1,5 * <br> --- | 1 | |
| A | US-A-3 961 350 (HEWLETT PACKARD) <br> * Ansprüche 1,6 * <br> --- | 1 | |
| A | DE-A-2 359 787 (SIEMENS) <br> * Seite 10, Abschnitt 2 - Seite 11, Abschnitt 3 * <br> --- | 3,5 | |
| A | DE-B-1 273 073 (SIEMENS) <br> --- | | |
| A | US-A-4 403 242 (HITACHI) <br> ----- | | |

**RECHERCHIERTE SACHGEBIETE (Int. Cl.4)**

H 01 L

Der vorliegende Recherchenbericht wurde für alle Patentansprüche erstellt

| Recherchenort | Abschlußdatum der Recherche | Prüfer |
|---|---|---|
| DEN HAAG | 03-08-1988 | DE RAEVE R.A.L. |